# EUROPEAN PATENT SPECIFICATION

(11) **EP 2 182 565 B1**
(45) Date of publication and mention of the grant of the patent: **06.12.2017**
(21) Application number: 09252487.5
(22) Date of filing: 27.10.2009
(51) Int. Cl.: H01L 51/52

(54) **Light emitting display and method of manufacturing the same**
Lichtemittierende Anzeige und Herstellungsverfahren dafür
Affichage électroluminescent et son procédé de fabrication

(30) Priority: 29.10.2008 KR 20080106221
(43) Date of publication of application: 05.05.2010
(73) Proprietor: Samsung Display Co., Ltd., Gyeonggi-do (KR)
(72) Inventor: Lee, Sun-Young, Yongin-City, Gyunggi-do (KR); Zang, Dong-Sik, Yongin-City, Gyunggi-do (KR); Lee, Jong-Hyuk, Yongin-City, Gyunggi-do (KR); Yoon-Hyeung, Cho, Yongin-City, Gyunggi-do (KR); Min-Ho, Oh, Yongin-City, Gyunggi-do (KR); Byoung-Duk, Lee, Yongin-City, Gyunggi-do (KR); So-Young, Lee, Yongin-City, Gyunggi-do (KR)
(74) Representative: Mounteney, Simon James

(56) References cited:
- US-A- 6 081 071
- US-A1- 2004 251 827
- US-A1- 2005 110 404
- US-A1- 2008 012 476
- US-A1- 2008 239 637

## Description

### BACKGROUND

### 1. Field of the Invention

The present invention relates to a light emitting display and a method of manufacturing the same, and more particularly to, a light emitting display having an inert liquid filling material between a substrate on which a light emitting device is formed and a sealing substrate, and a method of manufacturing the same.

### 2. Discussion of Related Art

Since a light emitting device such as an organic light emitting diode (OLED) includes organic materials vulnerable to moisture or oxygen, it is desirable to protect the OLED against moisture and/or oxygen using a sealing member.

Since a light emitting display using an OLED typically has a wide viewing angle, high contrast and response speed, and low power consumption, in spite of its vulnerability to moisture or oxygen, light emitting displays are widely used in personal portable apparatuses, such as MP3 players, mobile telephones, and televisions (TV). The thicknesses of light emitting displays have been gradually reduced in accordance with the requests of users.

However, when the thickness of a substrate of a light emitting display is reduced to no more than about 0.3 mm in order to reduce the thickness thereof, it is difficult to maintain the mechanical integrity of the device under stresses such as falling and twisting. Loss of mechanical integrity can compromise the sealed state of the device, thereby reducing the life of the organic light emitting display.

US 2008/0239637 discloses a display device that includes a display panel including an organic light emitting diode, an encapsulation member covering the display panel, a first sealant disposed between the display panel and the encapsulation member and surrounding the organic light emitting diode, and a second sealant disposed between the first sealant and the organic light emitting diode and surrounding the organic light emitting diode.

US 6 081 071 discloses an electroluminescent apparatus including an organic electroluminescent device carried by a glass substrate and a glass cover sealed with the glass substrate at a perimeter seal bounding the organic electroluminescent device in a cavity. The perimeter seal can include a cured epoxy adhesive seal sealingly engaging the glass cover with the glass substrate, and desiccant and/or inert fluorocarbon liquid disposed proximate the cured epoxy adhesive.

US 2005/0110404 discloses a method of manufacturing an OLED display using Fluorinert (3M) to seal the space in between the substrate and the encapsulating plate.

### SUMMARY OF THE INVENTION

Accordingly, it is an object to provide a light emitting display capable of securing mechanical reliability and of increasing a life and a method of manufacturing the same.

It is another object to provide a light emitting display capable of securing mechanical reliability while using an inorganic sealing material that effectively prevents moisture or oxygen from penetrating and a method of manufacturing the same.

In order to achieve the foregoing and/or other objects, according to one aspect of the present invention, there is provided a light emitting display including: a first substrate on which a plurality of light emitting devices are formed; a second substrate disposed to face the first substrate so as to define a space between the light emitting devices and the second substrate; a dam member, comprising an inorganic material, disposed between the first substrate and the second substrate to surround the plurality of light emitting devices; an inorganic sealing material comprising frit disposed between the first substrate and the second substrate on an outward side of the dam member and attaching the first substrate and the second substrate; and a filling material provided between the first substrate and the second substrate on an inward side of the dam member. The filling material is formed of at least one inert fluorocarbon based liquid, wherein the filling material is arranged to fill the space between the light emitting devices and the second substrate and the dam member comprises a reflecting layer arranged to reflect a laser or infrared rays formed on the surface of the dam member.

The light emitting devices may comprise first electrodes, organic light emitting layers and second electrodes.

The filling material may be provided between the first substrate and the second substrate to be in contact with the second electrodes.

The dam member comprises an inorganic material.

The inorganic material may comprise frit.

A reflecting layer that reflects a laser or infrared rays is formed on a surface of the dam member. The reflecting layer may comprise at least one selected from the group consisting of Au, Ag, Pt, and Al.

The dam member may be disposed to be in contact with the inorganic sealing material.

In an example not forming part of the present invention, the dam member may comprise an organic material. The organic material may comprise at least one selected from the group consisting of epoxy, epoxy acrylate, bisphenol A type epoxy, cycloaliphatic epoxy resin, phenyl silicone resin or rubber, and acrylic epoxy resin.

The inorganic sealing material comprises frit. The frit is melted by a laser or infrared rays.

The frit may comprise a transition metal compound.

In order to achieve the foregoing and/or other objects, according to another aspect of the present invention, there is provided a method of manufacturing a light emitting display including: providing a first substrate on which a plurality of light emitting devices are formed, providing a second substrate; forming an inorganic sealing material comprising frit along an edge of the second substrate; forming a dam member, comprising an inorganic material, on the second substrate on an inward side of the inorganic sealing material to surround the plurality of light emitting devices, the dam member comprising a reflecting layer arranged to reflect a laser or infrared rays formed on the surface of the dam member, dropping a filling material to an inward side of the dam member, the filling material being formed of at least one inert fluorocarbon based liquid, disposing the first substrate and the second substrate to face each other so as to define a space between the second substrate and the light emitting devices, and attaching the inorganic sealing material to the first substrate and the second substrate to seal the plurality of light emitting devices by melting the inorganic sealing material by a laser or infrared rays. The filling material is arranged to fill the space between the light emitting devices and the second substrate.

The forming the inorganic sealing material may comprise applying frit paste; and drying or annealing the applied frit paste.

The forming the dam member may comprise: applying frit paste; and drying or annealing the applied frit paste and hardening the frit paste.

The dam member may be formed to be in contact with the inorganic sealing material.

The disposing the first substrate and the second substrate to face each other may be performed at a pressure lower than atmospheric pressure.

The method may further comprise compressing the first substrate and the second substrate so that the filling material fills a space between the first substrate and the second substrate on the inward side of the dam member.

The sealing the light emitting devices comprises attaching the first substrate to the second substrate by melting the inorganic sealing material.

The inorganic sealing material is melted by a laser or infrared rays.

The attaching the inorganic sealing material to the first substrate and the second substrate may further comprise providing a mask or a protecting film only in a pixel region of the display.

The present invention as described above seals an light emitting device using an inorganic sealing material which effectively blocks hydrogen or oxygen and fills a space between substrates with an inert liquid filling material to improve pressure resistance. The inert liquid filling material, such as a perfluorocarbon or fluorinert, is a colorless, odorless, nontoxic and inert material, has a high stability not to react to the material of the light emitting device, and maintains pressure resistance between the substrates to allow a sealed state not to be easily broken by means of impact or the like. Therefore, mechanical reliability is improved so that the life of a light emitting display can be increased, and a passivation film for protecting a cathode electrode is omitted to simplify the manufacturing process.

Also, in a conventional light emitting display, since a space between a substrate and a sealing substrate is empty, the substrate may droop to generate Newton's ring or the display is vulnerable to impact. In the light emitting display according to the present invention, however, the space between the substrate and the sealing substrate is filled with a liquid filling material with a refractivity similar to the refractivity of a glass substrate, so that Newton's ring does not occur and visibility is high.

According to a first aspect of the invention, there is provided a light emitting display as set out in Claim 1. Preferred features of this aspect are set out in Claims 2 to 8.

According to a second aspect of the invention, there is provided a method as set out in Claim 9. Preferred features of this aspect are set out in Claims 10 to 16.

### BRIEF DESCRIPTION OF THE DRAWINGS

These and/or other aspects and advantages of the invention will become apparent and more readily appreciated from the following description of the preferred embodiments, taken in conjunction with the accompanying drawings of which:
FIG. 1 is a perspective view illustrating a light emitting display according to an embodiment of the present invention;
FIG. 2 is a cross-sectional view taken along section line I1-I2 of FIG. 1;
FIG. 3 is a cross-sectional view illustrating the light emitting device of FIG. 1;
FIGS. 4A and 4B are plan views illustrating an embodiment of a method of manufacturing the light emitting display according to the present invention; and
FIGS. 5A to 5F are cross-sectional views illustrating the embodiment of the method of manufacturing the light emitting display according to the present invention.

### DETAILED DESCRIPTION OF PREFERRED EMBODIMENTS

Hereinafter, embodiments of the present invention will be described in detail with reference to the accompanying drawings. However, the embodiments set forth herein are provided so that those skilled in the art can fully understand the present invention and thus, the present invention can be embodied in different forms and should not be construed as limited to the embodiments set forth herein. Here, when a first element is described as being coupled to a second element, the first element may be not only directly coupled to the second element but may also be indirectly coupled to the second element via one or more third elements. Further, elements that are not essential to a complete understanding are omitted for clarity. Also, like reference numerals refer to like elements throughout.

In order to increase the life of an organic light emitting display, it is useful to employ an inorganic sealing material that effectively prevents moisture or oxygen from penetrating. However, the inorganic sealing material easily falls off by means of impact or twisting to deteriorate mechanical reliability.

Therefore, embodiments of the present invention provide a light emitting display capable of increasing a life and of improving mechanical reliability using an inorganic sealing material that effectively prevents moisture or oxygen from penetrating and a method of manufacturing the same.

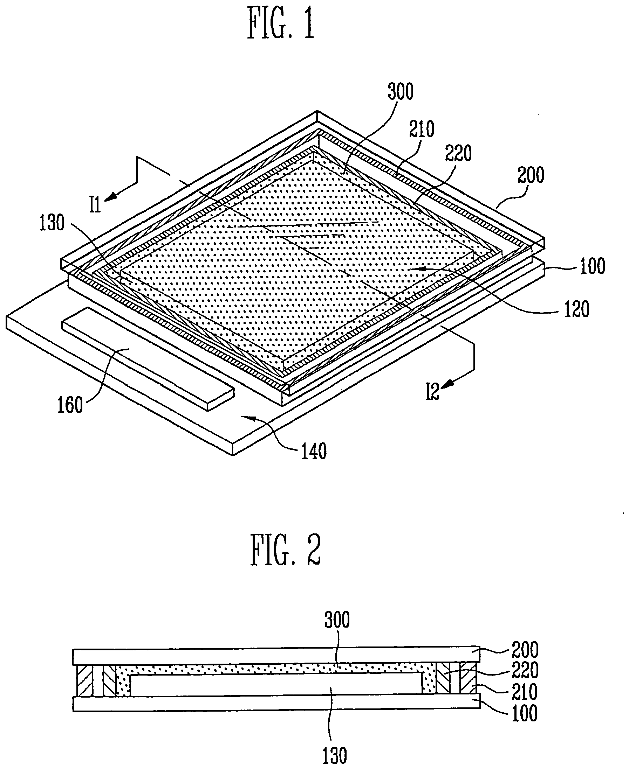

FIG. 1 is a perspective view illustrating a light emitting display according to an embodiment of the present invention, and FIG. 2 is a cross-sectional view taken along section line I1-I2 of FIG. 1.

Referring to FIGS. 1 and 2, the light emitting display of this embodiment the present invention includes a substrate 100 on which a plurality of light emitting devices 130 are formed, a sealing substrate 200 disposed to face the substrate 100, a dam member 220 provided between the substrate 100 and the sealing substrate 200 to surround the plurality of light emitting devices 130, an inorganic sealing material 210 provided between the substrate 100 and the sealing substrate 200 outside the dam member 220 to attach the substrate 100 to the sealing substrate 200, and an inert liquid filling material 300 provided between the substrate 100 and the sealing substrate 200 inside the dam member 220.

The substrate 100 is defined as a pixel region 120 and a non-pixel region 140 around the pixel region 120. The plurality of light emitting devices 130 are formed in the pixel region 120, and a driving circuit 160 for driving the plurality of light emitting devices 130 is formed in the non-pixel region 140.

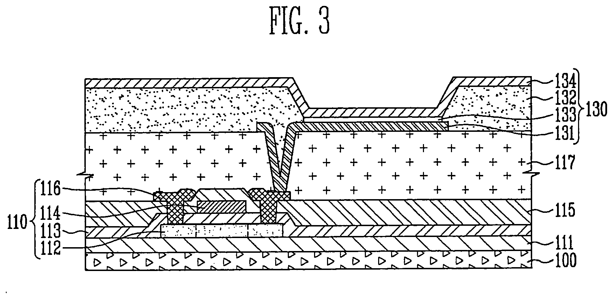

Referring to FIG. 3, the light emitting devices 130, for example, may be organic light emitting diodes (OLEDs) that include anode electrodes 131, cathode electrodes 134 and organic light emitting layers 133 formed between the anode electrodes 131 and the cathode electrodes 134. The organic light emitting layers 133 are formed in a light emitting region (a region where the anode electrode 131 is exposed) defined by a pixel definition layer 132 and may include a hole injection layer, a hole transport layer, an electron transport layer and an electron injection layer.

Also, the light emitting device 130 may be coupled to a thin film transistor for controlling the operation and a capacitor for maintaining a signal. The thin film transistor 110 includes a semiconductor layer 112 providing a source and drain region and a channel region, a gate electrode 114 insulated from the semiconductor layer 112 by a gate insulating layer 113, and a source and drain electrode 116 coupled to the semiconductor layer 112 in the source and drain region through a contact hole formed in the insulating layer 115 and the gate insulating layer 113. Reference numerals 111 and 117, not explained, are a buffer layer and a planarization layer, respectively.

The sealing substrate 200 is provided to overlap with the pixel region 120 and a part of the non-pixel region 140. In the case of a front emission type, the sealing substrate 200 can be formed of a transparent material such as glass. In the case of a rear emission type, the sealing substrate 200 can be formed of an opaque material.

The inorganic sealing material 210 includes frit, which is melted by a laser or infrared rays to be attached to the substrate 100 and the sealing substrate 200. The inorganic sealing material 210 is provided between the substrate 100 and the sealing substrate 200 to surround the light emitting devices 130 so that the infiltration of moisture or oxygen from the outside is prevented.

The dam member 220 prevents the filling material 300 from flowing to keep the filling material 300 in shape. The dam member 220 is provided to prevent heat from being transmitted to the light emitting devices 130 while the inorganic sealing material 210 is attached to the substrate 100 and the sealing substrate 200. The dam member 220 is formed of an inorganic material.

The inorganic material may employ frit. In this case, frit that transmits or reflects a laser or infrared rays is used or a reflecting layer is formed on the surface of the dam member 220 using metal having a high reflectance in an infrared region such as Au, Ag, Pt, Al, or the like so that a laser or infrared rays are reflected. In an example not forming part of the present invention, the dam member comprises an organic material that may be at least one material selected from the group consisting of epoxy, epoxy acrylate, and silicones (such as bisphenol A type epoxy, cycloaliphatic epoxy resin, phenyl silicone resin or rubber, acrylic epoxy resin, and the like).

The dam member 220 may be formed to be in contact with the inorganic sealing material 210 or to be parallel separated from the inorganic sealing material 210 by a predetermined distance. For example, the dam member 220 may be in contact with the inorganic sealing material 210 when the dam member 220 includes an inorganic material, and may be separated from the inorganic sealing material 210 by 50 µm or more when the dam member 220 includes an organic material. When the dam member 220 of an organic material is formed to be in contact with the inorganic sealing material 210, the dam member 220 is thermally decomposed while the inorganic sealing material 210 is attached to the substrate 100 and the sealing substrate 200, thereby generating out gas.

The inert filling material 300 is provided to fill an inner space defined by the dam member 220, and thus it preferably employs a colorless material having a transmittance of not less than 90% in a visible region such as a glass substrate. Also, the inert filing material 300 preferably has a high stability not reacting to the material of the light emitting device 130. An inert liquid used as the filling material 300 is an inert fluorocarbon based liquid. The inert liquid may be a perfluorocarbon based liquid, for example a perfluorocarbon or a mixture of perfluorocarbons. The inert liquid may be selected from the group consisting of one or more perfluorocarbons and fluorinert. The inert liquid can therefore be a colorless, odorless, nontoxic and inert material that has a high stability so that it does not react to an electrode formed of a metal material, in particular, the cathode electrode 134.

In order to protect the cathode electrode 134 after the light emitting device 130 is formed as shown in FIG. 3, an organic or inorganic passivation film (not shown) is required to be formed on the cathode electrode 134. In this case, however, a further process is involved and the thickness of the display becomes thicker. However, since embodiments of the present invention use the filling material 300 formed of an inert liquid not reacting with a metal material, it can be implemented to have a structure where the cathode electrode 134 is exposed, making it possible to simplify the process and structure thereof.

Next, a method of manufacturing a light emitting display will now be described in detail.

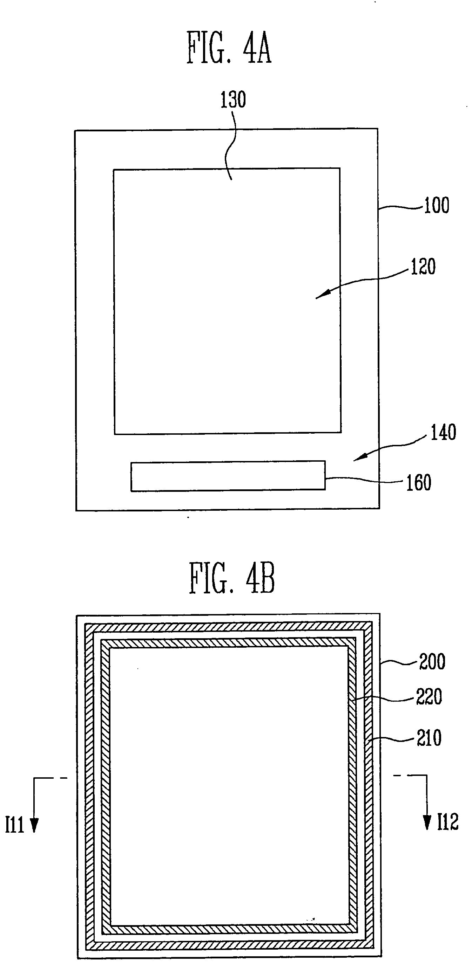

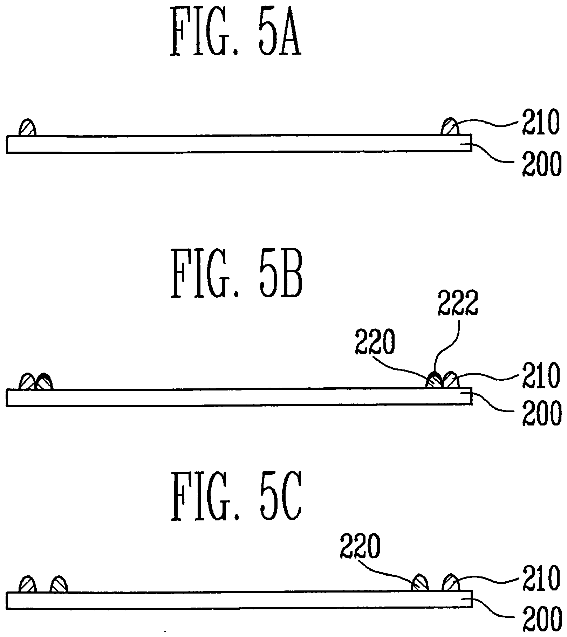

FIGS. 4A and 4B are plan views illustrating a method of manufacturing the light emitting display according to the present invention. FIGS. 5A to 5F are cross-sectional views illustrating the method of manufacturing the light emitting display according to the present invention, taken along section line I11-I12 of FIG. 4B.

Referring to FIG. 4A, first, the substrate 100 on which the plurality of light emitting devices 130 are formed is provided. The substrate 100 is divided into the pixel region 120 and the non-pixel region 140 around the pixel region 120. The plurality of light emitting devices 130 can be formed in the pixel region 120 of the substrate 100, and the driving circuit 160 for driving the light emitting devices 130 can be formed in the non-pixel region 140.

The light emitting devices 130 include the OLEDs having the anode electrodes, the organic light emitting layers, and the cathode electrodes. Also, it may further include thin film transistors (TFTs) for controlling the operation of the OLEDs and capacitors for maintaining signals. A process of manufacturing an OLED is illustrated in the Korean Patent Publications No. 2002-0047889 (published on June 22, 2002) and No. 2003-0092873 (published on December 6, 2003).

Referring to FIGS. 4B and 5A, the sealing substrate 200 for sealing the light emitting devices 130 of the pixel region 120 is provided. The sealing substrate 200 may overlap with the pixel region 120 and a part of the non-pixel region 140. The sealing substrate 200 employs a transparent substrate such as glass in case of a front emission structure or an opaque substrate in case of a rear emission type.

An inorganic sealing material 210 is formed along the edge of the sealing substrate 200. The inorganic sealing material 210 comprises frit and may be formed by applying using dispensers or a screen printing method. Frit commonly means a powdery glass material. However, in the present embodiment of the invention, frit refers to paste including a main material such as SiO2 mixed with a laser or infrared ray absorbing material, an organic binder, and a filler for reducing a thermal expansion coefficient. The frit in paste is hardened, as the organic binder and moisture are removed from the frit via a drying or annealing process. The laser or infrared ray absorbing material may include a transition metal compound, for example, a vanadium compound. After the inorganic sealing material 210 is formed on the sealing substrate 200, a washing process may be performed.

Referring to FIGS. 4B, 5B, and 5C, the dam member 220 is formed on the sealing substrate 200 on the inward side of the inorganic sealing material 210 to surround the pixel region 120. The dam member 220 comprises an inorganic material and may be applied by dispensers or screen printing. At this time, the amount of the inorganic material is determined in consideration of the distance from an outmost light emitting device 130 in the pixel region 120 to the inorganic sealing material 210 and the height of the dam member 220. The height of the dam member 220 is determined by the height of the inorganic sealing material 210 and is preferably adjusted to be equal to or lower than the height of the inorganic sealing material 210.

The inorganic material may employ frit. In this case, the dam member 220 can be formed in a process of forming the inorganic sealing material 210. A reflecting layer 222 is formed on the surface of the dam member 220 in order to reflect a laser or infrared rays, as illustrated in FIG. 5B. For example, after applying the frit in paste, followed by drying or annealing, the frit is hardened to form the dam member 220. Then, metal such as Au, Ag, Pt, or Al having a high reflectance in the infrared region is applied to the surface of the dam member 220 to form the reflecting layer 222. In an example not forming part of the present invention, the dam member comprises an organic material that may be a material selected from the group consisting of epoxy, epoxy acrylate, and silicones (such as bisphenol A type epoxy, cycloaliphatic epoxy resin, phenyl silicone resin or rubber, acrylic epoxy resin, etc.).

The dam member 220 is formed to be in contact with the inorganic sealing material 210, as illustrated in FIG. 5B, or, in an example not forming part of the invention, may be separated from the inorganic sealing material 210 by a predetermined distance, as illustrated in FIG. 5C. For example, when the dam member 220 is formed of an inorganic material, it is in contact with the inorganic sealing material 210. In this case, the area of the non-pixel region, i.e., a dead space, may be reduced. In addition, when being formed of an organic material, the dam member 220 is preferably separated from the inorganic sealing material 210 by no less than about 50 µm. Since the organic material typically has low viscosity to be easily applied, the dam member 220 may be easily collapsed by stress such as a pressure difference. Therefore, the dam member 220 is formed and then pre-hardened so that it becomes solid in structure to enhance its function. The dam member 220 is pre-hardened by heat, an electron beam, or an ultraviolet ray in accordance with the kind of the organic material and so as not to be damaged by stress in a process of attaching the substrate 100 to the sealing substrate 200.

In another embodiment, in a process of forming the inorganic sealing material 210 or the dam member 220, a dummy sealing material (not shown) may be formed of epoxy, frit, etc. along the outermost edge of the sealing substrate 200. The dummy sealing material is formed outside the inorganic sealing material 210 to collectively seal up the space between the substrate 100 and the sealing substrate 200. In the case of a mother substrate, the dummy sealing material is disposed on the outermost edge thereof.

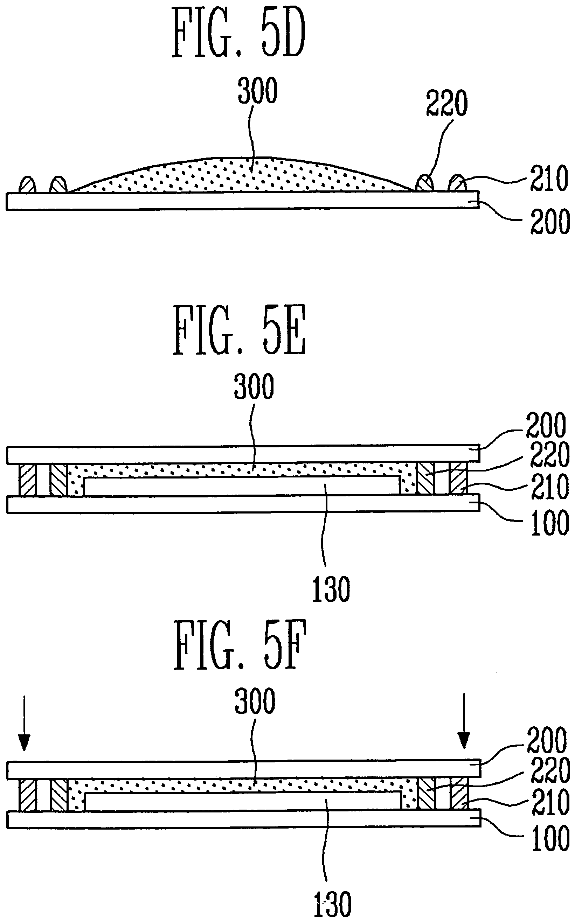

Referring to FIG. 5D, the inert liquid filling material 300 is provided on the sealing substrate 200 on the inward side of the region defined by the dam member 220. The filling material 300 is preferably a colorless material having a transmittance of not less than about 90% in a visible ray region and has stability not reacting to the material of the light emitting devices 130. An inert liquid used as the filling material 300 is an inert fluorocarbon based liquid. The inert liquid may be a perfluorocarbon based liquid, for example a perfluorocarbon or a mixture of perfluorocarbons. The inert liquid may be selected from the group consisting of perfluorocarbon and fluorinert.

The filling material 300 may be provided using ink jetting, dispensers, screen printing, one drop filling (ODF) or the like. For example, the proper amount of the filling material 300 can be dropped to the sealing substrate 200 on the inward side of the dam member 220 using a one drop filling (ODF) device. In this case, the proper amount of the filling material 300 in proportion to the volume of the theoretical internal space can be easily controlled.

Referring to FIG. 5E, the substrate 100 is disposed to face the sealing substrate 200. For example, the substrate 100 is mounted on an upper chuck of an attaching device and the sealing substrate 200 is mounted on a lower chuck of the attaching device, and then the substrate 100 and the sealing substrate 200 are attached to each other. As the substrate 100 and the sealing substrate 200 are attached to each other, the light emitting devices 130 are covered with the filling material 300, and the flow of the filling material 300 is prevented by the dam member 220 so that the filling material is kept in shape. At this time, the substrate 100 and the sealing substrate 200 are attached to each other under a pressure lower than atmospheric pressure so as not to form bubbles or voids between the substrate 100 and the sealing substrate 200. In addition, the substrate 100 and the sealing substrate 200 are pressed together so that the space between the light emitting devices 130 and the sealing substrate 200 is completely filled with the filling material 300.

Referring to FIG. 5F, a laser or infrared rays are irradiated along the inorganic sealing material 210 while the substrate 100 and the sealing substrate 200 are attached to each other. As the laser or infrared rays are absorbed to generate heat, the inorganic sealing material 210 is melted to be attached to the substrate 100 and the sealing substrate 200, and accordingly the light emitting devices 130 are sealed. Such a sealing process is performed preferably after the dummy sealing material is hardened so that the space between the substrate 100 and the sealing substrate 200 is kept a vacuum.

When a laser or infrared rays are irradiated along the inorganic sealing material 210, a mask or a protecting film (not shown) is used to irradiate the laser and infrared rays only to a desired region. When the dam member 220 includes an inorganic material that transmits or reflects a laser or infrared rays or when the reflecting layer 222 is disposed on the surface of the dam member 220, the mask or the protecting film is disposed only in the pixel region 120 so that the laser or infrared rays are not irradiated. When the dam member 220 includes an organic material, the mask or the protecting film is disposed in the pixel region 120 and the non-pixel region 140 where the dam member 220 is formed so that the laser or infrared rays do not irradiated.

Assuming that a dam member 220 is not formed, since heat generated in the irradiation of a laser or infrared rays is easily transmitted to the filling material 300, a temperature rise may momentarily occurs to cause a damage to the light emitting devices 130. In the present invention, however, the transmission of heat is effectively reduced or prevented by the dam member 220 as well as the region filled with the filling material 300 and the shape thereof are maintained as they are.

Although the above embodiment has been described with the inorganic sealing material 210 sealing only the pixel region 120, not limited thereto, the inorganic sealing material 210 may further seal the driving circuit 160. In addition, the inorganic sealing material 210 and the dam member 220 are described as being integrated with each other on the sealing substrate 200, but may be integrated with each other on the substrate 100 and may have a double or multiple structure. For example, in order to improve sealing effect, the inorganic sealing material 210 may be formed in a double or multiple structure, or the dam member 220 may have a double or multiple structure in order to improve heat shielding effect.

In addition, in the above embodiment, the filling material 300 is filled before attaching the substrate 100 and the sealing substrate 200 to each other. However, the filling material 300 may be filled after the substrate 100 and the sealing substrate 200 are attached to each other in accordance with the properties of material.

## Claims

1. A light emitting display comprising:
a first substrate (100) on which a plurality of light emitting devices (130) are formed;
a second substrate (200) disposed to face the first substrate (100) so as to define a space between the light emitting devices (130) and the second substrate (200);
a dam member (220), comprising an inorganic material, disposed between the first substrate (100) and the second substrate (200) to surround the plurality of light emitting devices (130);
an inorganic sealing material (210) comprising frit disposed between the first substrate (100) and the second substrate (200) on an outward side of the dam member (220) and attaching the first substrate (100) and the second substrate (200); and
a filling material (300) provided between the first substrate (100) and the second substrate (200) on an inward side of the dam member (220);
wherein the filling material (300) is formed of at least one inert fluorocarbon based liquid, wherein the filling material (300) is arranged to fill the space between the light emitting devices (130) and the second substrate (200); and
**characterized in that** the dam member (220) comprises a reflecting layer arranged to reflect a laser or infrared rays formed on the surface of the dam member (220).

2. A light emitting display according to Claim 1, wherein the inert liquid is a perfluorocarbon based liquid, optionally a perfluorocarbon or a mixture of perfluorocarbons.

3. A light emitting display according to Claim 1 or 2, wherein the inert liquid is selected from the group consisting of perfluorocarbon, and a fluorinert.

4. A light emitting display according to any one of claims 1 to 3, wherein the light emitting devices (130) comprise first electrodes (131), organic light emitting layers (133) and second electrodes (134).

5. A light emitting display according to claim 4, wherein the filling material is provided between the first substrate (100) and the second substrate (200) to be in contact with the second electrodes.

6. A light emitting display according to any one of the preceding claims, wherein the reflecting layer comprises at least one selected from the group consisting of Au, Ag, Pt, and Al.

7. A light emitting display according to any one of the preceding claims, wherein the dam member (220) is frit and is disposed to be in contact with the inorganic sealing material (210).

8. A light emitting display as claimed in any one of the preceding claims, wherein the inorganic sealing material includes frit comprising a transition metal compound.

9. A method of manufacturing a light emitting display comprising:
providing a first substrate (100) on which a plurality of light emitting devices (130) are formed;
providing a second substrate (200);
forming an inorganic sealing material (210) comprising frit along an edge of the second substrate;
forming a dam member (220), comprising an inorganic material, on the second substrate (200) on an inward side of the inorganic sealing material (210) to surround the plurality of light emitting devices (130), the dam member (220) comprising a reflecting layer arranged to reflect a laser or infrared rays formed on the surface of the dam member (220) ;
dropping a filling material to an inward side of the dam member (220), the filling material being formed of at least one inert fluorocarbon based liquid;
disposing the first substrate (100) and the second substrate (200) to face each other so as to define a space between the second substrate (200) and the light emitting devices (130); and
attaching the inorganic sealing material (210) to the first substrate (100) and the second substrate (200) to seal the plurality of light emitting devices (130) by melting the inorganic sealing material (210) by a laser or infrared rays;
wherein the filling material (300) is arranged to fill the space between the light emitting devices (130) and the second substrate (200).

10. A method according to Claim 9, wherein the inert liquid is a perfluorocarbon based liquid, optionally a perfluorocarbon or a mixture of perfluorocarbons.

11. A method according to Claim 9 or 10, wherein the inert liquid is selected from the group consisting of perfluorocarbon and a fluorinert.

12. A method according to any one of claims 9 to 11, wherein the forming the dam member (220) comprises:
applying frit paste; and
drying or annealing the applied frit paste and optionally hardening the frit paste.

13. A method according to claim 12, wherein the dam member (220) is formed to be in contact with the inorganic sealing material (210).

14. A method according to claim 13, wherein the attaching the inorganic sealing material (210) to the first substrate (100) and the second substrate (200) further comprises providing a mask or a protecting film only in a pixel region (120) of the display.

15. A method according to any one of claims 9 to 14, wherein the disposing the first substrate (100) and the second substrate (200) to face each other is performed at a pressure lower than atmospheric pressure.

16. A method according to any one of claims 9 to 15, further comprising compressing the first substrate (100) and the second substrate (200) so that the filling material (300) fills a space between the first substrate (100) and the second substrate (200) on the inward side of the dam member (220).

## Patentansprüche

1. Lichtemittierende Anzeige, umfassend:
ein erstes Substrat (100), auf dem eine Vielzahl von lichtemittierenden Bauelementen (130) ausgebildet ist;
ein zweites Substrat (200), das so angeordnet ist, dass es dem ersten Substrat (100) gegenüberliegt, um dadurch einen Raum zwischen den lichtemittierenden Bauelementen (130) und dem zweiten Substrat (200) zu definieren;
ein Dammelement (220), das ein anorganisches Material umfasst und so zwischen dem ersten Substrat (100) und dem zweiten Substrat (200) angeordnet ist, dass es die Vielzahl von lichtemittierenden Bauelementen (130) umgibt;
ein anorganisches Dichtungsmaterial (210), das Fritte umfasst, das zwischen dem ersten Substrat (100) und dem zweiten Substrat (200) auf einer Außenseite des Dammelements (220) angeordnet ist und das erste Substrat (100) und das zweite Substrat (200) befestigt; und
ein Füllmaterial (300), das zwischen dem ersten Substrat (100) und dem zweiten Substrat (200) auf einer Innenseite des Dammelements (220) bereitgestellt ist;
worin das Füllmaterial (300) aus mindestens einer inerten fluorkohlenstoffbasierten Flüssigkeit gebildet ist, worin das Füllmaterial (300) dafür eingerichtet ist, den Raum zwischen den lichtemittierenden Bauelementen (130) und dem zweiten Substrat (200) zu füllen; und
**dadurch gekennzeichnet, dass** das Dammelement (220) eine auf der Oberfläche des Dammelements (220) ausgebildete reflektierende Schicht umfasst, die dafür eingerichtet ist, einen Laser oder Infrarotstrahlen zu reflektieren.

2. Lichtemittierende Anzeige nach Anspruch 1, worin die inerte Flüssigkeit eine perfluorkohlenstoffbasierte Flüssigkeit ist, optional ein Perfluorkohlenstoff oder eine Mischung aus Perfluorkohlenstoffen.

3. Lichtemittierende Anzeige nach Anspruch 1 oder 2, worin die inerte Flüssigkeit aus der Gruppe ausgewählt wird, die aus Perfluorkohlenstoff und einem Fluorinert besteht.

4. Lichtemittierende Anzeige nach einem der Ansprüche 1 bis 3, worin die lichtemittierenden Bauelemente (130) erste Elektroden (131), organische lichtemittierende Schichten (133) und zweite Elektroden (134) umfassen.

5. Lichtemittierende Anzeige nach Anspruch 4, worin das Füllmaterial so zwischen dem ersten Substrat (100) und dem zweiten Substrat (200) bereitgestellt ist, dass es in Kontakt mit den zweiten Elektroden ist.

6. Lichtemittierende Anzeige nach einem der vorhergehenden Ansprüche, worin die reflektierende Schicht mindestens eines umfasst, das aus der Gruppe ausgewählt wird, die aus Au, Ag, Pt und Al besteht.

7. Lichtemittierende Anzeige nach einem der vorhergehenden Ansprüche, worin das Dammelement (220) Fritte ist und so angeordnet ist, dass es in Kontakt mit dem anorganischen Dichtungsmaterial (210) ist.

8. Lichtemittierende Anzeige nach einem der vorhergehenden Ansprüche, worin das anorganische Dichtungsmaterial Fritte aufweist, die eine Übergangsmetallverbindung umfasst.

9. Verfahren zum Herstellen einer lichtemittierenden Anzeige, umfassend:
Bereitstellen eines ersten Substrats (100), auf dem eine Vielzahl von lichtemittierenden Bauelementen (130) ausgebildet wird;
Bereitstellen eines zweiten Substrats (200);
Ausbilden eines anorganischen Dichtungsmaterials (210), das Fritte umfasst, entlang einem Rand des zweiten Substrats;
Ausbilden eines Dammelements (220), das ein anorganisches Material umfasst, auf dem zweiten Substrat (200) auf einer Innenseite des anorganischen Dichtungsmaterials (210), sodass es die Vielzahl von lichtemittierenden Bauelementen (130) umgibt, wobei das Dammelement (220) eine auf der Oberfläche des Dammelements (220) ausgebildete reflektierende Schicht umfasst, die dafür eingerichtet ist, einen Laser oder Infrarotstrahlen zu reflektieren;
Tropfen eines Füllmaterials auf eine Innenseite des Dammelements (220), wobei das Füllmaterial aus mindestens einer inerten fluorkohlenstoffbasierten Flüssigkeit gebildet ist;
Anordnen des ersten Substrats (100) und des zweiten Substrats (200), sodass sie einander gegenüberliegen, um dadurch einen Raum zwischen dem zweiten Substrat (200) und den lichtemittierenden Bauelementen (130) zu definieren; und
Befestigen des anorganischen Dichtungsmaterials (210) am ersten Substrat (100) und zweiten Substrat (200), um die Vielzahl von lichtemittierenden Bauelementen (130) abzudichten, indem das anorganische Dichtungsmaterial (210) durch einen Laser oder Infrarotstrahlen geschmolzen wird;
worin das Füllmaterial (300) dafür eingerichtet ist, den Raum zwischen den lichtemittierenden Bauelementen (130) und dem zweiten Substrat (200) zu füllen.

10. Verfahren nach Anspruch 9, worin die inerte Flüssigkeit eine perfluorkohlenstoffbasierte Flüssigkeit ist, optional ein Perfluorkohlenstoff oder eine Mischung aus Perfluorkohlenstoffen.

11. Verfahren nach Anspruch 9 oder 10, worin die inerte Flüssigkeit aus der Gruppe ausgewählt wird, die aus Perfluorkohlenstoff und einem Fluorinert besteht.

12. Verfahren nach einem der Ansprüche 9 bis 11, worin das Ausbilden des Dammelements (220) umfasst:
Auftragen einer Frittenpaste; und
Trocknen oder Tempern der aufgetragenen Frittenpaste und optional Aushärten der Frittenpaste.

13. Verfahren nach Anspruch 12, worin das Dammelement (220) so ausgebildet wird, dass es in Kontakt mit dem anorganischen Dichtungsmaterial (210) ist.

14. Verfahren nach Anspruch 13, worin das Befestigen des anorganischen Dichtungsmaterials (210) am ersten Substrat (100) und zweiten Substrat (200) ferner umfasst: Bereitstellen einer Maske oder einer Schutzschicht nur in einem Bildpunktbereich (120) der Anzeige.

15. Verfahren nach einem der Ansprüche 9 bis 14, worin das Anordnen des ersten Substrats (100) und des zweiten Substrats (200), sodass sie einander gegenüberliegen, bei einem niedrigeren Druck als Atmosphärendruck durchgeführt wird.

16. Verfahren nach einem der Ansprüche 9 bis 15, ferner umfassend: Zusammendrücken des ersten Substrats (100) und des zweiten Substrats (200), sodass das Füllmaterial (300) einen Raum zwischen dem ersten Substrat (100) und dem zweiten Substrat (200) auf der Innenseite des Dammelements (220) füllt.

## Revendications

1. Affichage électroluminescent comprenant :
un premier substrat (100) sur lequel une pluralité de dispositifs électroluminescents (130) sont formés ;
un second substrat (200) qui est disposé de manière à ce qu'il fasse face au premier substrat (100) de manière à définir un espace entre les dispositifs électroluminescents (130) et le second substrat (200) ;
un élément de barrage (220), comprenant un matériau inorganique, qui est disposé entre le premier substrat (100) et le second substrat (200) de manière à ce qu'il entoure la pluralité de dispositifs électroluminescents (130) ;
un matériau de scellement inorganique (210) comprenant une fritte qui est disposé entre le premier substrat (100) et le second substrat (200) sur un côté extérieur de l'élément de barrage (220) et qui fixe le premier substrat (100) et le second substrat (200) ; et
un matériau de remplissage (300) qui est prévu entre le premier substrat (100) et le second substrat (200) sur un côté intérieur de l'élément de barrage (220) ; dans lequel :
le matériau de remplissage (300) est formé à partir d'au moins un liquide à base de fluorocarbone inerte, dans lequel le matériau de remplissage (300) est agencé de manière à ce qu'il remplisse l'espace entre les dispositifs électroluminescents (130) et le second substrat (200) ; et
**caractérisé en ce que** l'élément de barrage (220) comprend une couche réfléchissante formée sur la surface de l'élément de barrage (220) qui est agencée de manière à ce qu'elle réfléchisse un rayon laser ou des rayons infrarouges.

2. Affichage électroluminescent selon la revendication 1, dans lequel le liquide inerte est un liquide à base de perfluorocarbone, en option un perfluorocarbone ou un mélange de perfluorocarbones.

3. Affichage électroluminescent selon la revendication 1 ou 2, dans lequel le liquide inerte est sélectionné parmi le groupe qui est constitué par le perfluorocarbone et un fluorinert.

4. Affichage électroluminescent selon l'une quelconque des revendications 1 à 3, dans lequel les dispositifs électroluminescents (130) comprennent des premières électrodes (131), des couches électroluminescentes organiques (133) et des secondes électrodes (134).

5. Affichage électroluminescent selon la revendication 4, dans lequel le matériau de remplissage est fourni entre le premier substrat (100) et le second substrat (200) de manière à ce qu'il soit en contact avec les secondes électrodes.

6. Affichage électroluminescent selon l'une quelconque des revendications précédentes, dans lequel la couche réfléchissante comprend au moins un élément chimique sélectionné parmi le groupe constitué par Au, Ag, Pt et Al.

7. Affichage électroluminescent selon l'une quelconque des revendications précédentes, dans lequel l'élément de barrage (220) est une fritte et il est disposé de manière à ce qu'il soit en contact avec le matériau de scellement inorganique (210).

8. Affichage électroluminescent selon l'une quelconque des revendications précédentes, dans lequel le matériau de scellement inorganique inclut une fritte qui comprend un composé de métal de transition.

9. Procédé de fabrication d'un affichage électroluminescent comprenant :
la fourniture d'un premier substrat (100) sur lequel une pluralité de dispositifs électroluminescents (130) sont formés ;
la fourniture d'un second substrat (200) ;
la formation d'un matériau de scellement inorganique (210) qui comprend une fritte le long d'un bord du second substrat ;
la formation d'un élément de barrage (220), qui comprend un matériau inorganique, sur le second substrat (200) sur un côté intérieur du matériau de scellement inorganique (210) de telle sorte qu'il entoure la pluralité de dispositifs électroluminescents (130), l'élément de barrage (220) comprenant une couche réfléchissante formée sur la surface de l'élément de barrage (220) qui est agencée de manière à ce qu'elle réfléchisse un rayon laser ou des rayons infrarouges ;
le versement au goutte-à-goutte d'un matériau de remplissage sur un côté intérieur de l'élément de barrage (220), le matériau de remplissage étant formé par au moins un liquide à base de fluorocarbone inerte ;
la disposition du premier substrat (100) et du second substrat (200) de manière à ce qu'ils se fassent face l'un l'autre de manière à définir un espace entre le second substrat (200) et les dispositifs électroluminescents (130) ; et
la fixation du matériau de scellement inorganique (210) sur le premier substrat (100) et sur le second substrat (200) de manière à sceller la pluralité de dispositifs électroluminescents (130) en fondant le matériau de scellement inorganique (210) au moyen d'un rayon laser ou de rayons infrarouges ; dans lequel :
le matériau de remplissage (300) est agencé de manière à ce qu'il remplisse l'espace entre les dispositifs électroluminescents (130) et le second substrat (200).

10. Procédé selon la revendication 9, dans lequel le liquide inerte est un liquide à base de perfluorocarbone, en option un perfluorocarbone ou un mélange de perfluorocarbones.

11. Procédé selon la revendication 9 ou 10, dans lequel le liquide inerte est sélectionné parmi le groupe qui est constitué par le perfluorocarbone et un fluorinert.

12. Procédé selon l'une quelconque des revendications 9 à 11, dans lequel la formation de l'élément de barrage (220) comprend :
l'application d'une pâte de fritte ; et
le séchage ou le recuit de la pâte de fritte appliquée et en option, le durcissement de la pâte de fritte.

13. Procédé selon la revendication 12, dans lequel l'élément de barrage (220) est formé de manière à ce qu'il soit en contact avec le matériau de scellement inorganique (210).

14. Procédé selon la revendication 13, dans lequel la fixation du matériau de scellement inorganique (210) sur le premier substrat (100) et sur le second substrat (200) comprend en outre l'application d'un masque ou d'un film de protection seulement dans une région de pixels (120) de l'affichage.

15. Procédé selon l'une quelconque des revendications 9 à 14, dans lequel la disposition du premier substrat (100) et du second substrat (200) de manière à ce qu'ils se fassent face l'un l'autre est réalisée à une pression inférieure à la pression atmosphérique.

16. Procédé selon l'une quelconque des revendications 9 à 15, comprenant en outre la compression du premier substrat (100) et du second substrat (200) de telle sorte que le matériau de remplissage (300) remplisse un espace entre le premier substrat (100) et le second substrat (200) sur le côté intérieur de l'élément de barrage (220).
